# EUROPEAN PATENT SPECIFICATION

(11) **EP 1 193 677 B1**
(45) Date of publication and mention of the grant of the patent: **07.05.2008**
(21) Application number: 01308339.9
(22) Date of filing: 28.09.2001
(51) Int. Cl.: G09G 3/32

(54) **Driving method for electro-optical device, electro-optical device, and electronic apparatus**
Verfahren zur Ansteuerung einer elektrooptischen Vorrichtung, elektrooptische Vorrichtung und elektronisches Gerät
Méthode de commande d'un dispositif électro-optique, dispositif électro-optique et appareil électronique

(30) Priority: 29.09.2000 JP 2000300856; 26.09.2001 JP 2001294717
(43) Date of publication of application: 03.04.2002
(73) Proprietor: Seiko Epson Corporation, Shinjuku-ku Tokyo 163-0811 (JP)
(72) Inventor: Kimura, Mutsumi, c/o Seiko Epson Corporation, Nagano-ken 392-8502 (JP)
(74) Representative: Sturt, Clifford Mark

(56) References cited:
- EP-A- 1 096 465
- EP-A- 1 168 291
- MIZUKAMI M ET AL: "6-Bit Digital VGA OLED" 2000 SID INTERNATIONAL SYMPOSIUM DIGEST OF TECHNICAL PAPERS. LONG BEACH, CA, MAY 16 - 18, 2000, SID INTERNATIONAL SYMPOSIUM DIGEST OF TECHNICAL PAPERS, SAN JOSE, CA: SID, US, vol. 31, 16 May 2000 (2000-05-16), pages 912-915, XP001078974
- INUKAI K ET AL: "4.0 in. TFT-OLED Displays and a Novel Digital Driving Method" 2000 SID INTERNATIONAL SYMPOSIUM DIGEST OF TECHNICAL PAPERS. LONG BEACH, CA, MAY 16 - 18, 2000, SID INTERNATIONAL SYMPOSIUM DIGEST OF TECHNICAL PAPERS, SAN JOSE, CA: SID, US, vol. 31, 16 May 2000 (2000-05-16), pages 924-927, XP002196013

## Description

The present invention relates to a driving method for an organic electro-luminescence display device, a driving method for an electro-optical device suitable for use with an organic electro-luminescence display device the electro-optical device, and an electronic apparatus provided with such an electro-optical device.

Attention is being given to organic electro-luminescence (electric-field luminescence) display devices using organic materials as luminescent materials of luminescent elements since they have a wide viewing angle, and will potentially meet market demands, i.e., demands for thinner, lighter, smaller, and lower power-consuming display devices.

Unlike conventional liquid crystal display devices, in organic electro-luminescence display devices, the luminescence state of the luminescent element must be controlled by a current. One such control method is the conductance control method (T. Shimoda, M. Kimura, et al., Proc. Asia Display 98, 217; M. Kimura, et al., IEEE Trans. Ele. Dev. 46, 2282 (1999); M. Kimura, et al., Proc. IDW 99, 171; and M. Kimura et al., Dig. AM-LCD 2000, to be published). In this method, the luminescence state of the luminescent element is controlled by a current value, which is an analog value, and more specifically, it is controlled by changing the potential applied to a gate electrode of a driving transistor for driving the luminescent element. When thin-film transistors having different current characteristics are used, however, the difference in the current characteristics of the individual transistors may sometimes directly result in the non-uniformity in the luminescence state of the luminescent elements.

Accordingly, the area ratio gray-scale method (M. Kimura, et al., Proc. Euro Display '99 Late-News Papers, 71, Japanese Unexamined Patent Application Publication No. 11-073158, M. Kimura, et al., Proc. IDW 99,171, M. Kimura, et al, J. SID, to be published; and M. Kimura, et al., Dig. AM-LCD 2000 to be published) has been proposed. In the area ratio gray-scale method, unlike the above-mentioned conductance control method, the luminescence state of the luminescent elements is controlled without using a luminescence state at an intermediate luminance. More specifically, in this method, a gray-scale is displayed as follows. Pixels disposed in a matrix are divided into a plurality of sub-pixels, and it is determined whether the luminescent elements contained in the sub-pixels are either in a complete luminescence state or a complete non-luminescence state. Then, among the plurality of sub-pixels, the total area of the sub-pixels in the complete luminescence state is changed. In the area ratio gray-scale method, it is not necessary to set an intermediate current value corresponding to the luminescence state of the intermediate luminance. Accordingly, the influence of the current characteristics of the transistors for driving the luminescent elements can be reduced, thereby achieving a uniform image quality. In this method, however, the number of gray-scale levels is restricted by the number of sub-pixels. For a greater number of gray-scale levels, pixels must be divided into a greater number of sub-pixels, which makes the pixel structure complicated.

Accordingly, the time ratio gray-scale method (M. Kimura, et al., Proc. IDW 99, 171; M. Kimura, et al., Dig. AM-LCD 2000, to be published; M. Mizukami, et al., Dig. SID 2000, 912; and K. Inukai, et al., Dig. SID 2000,924) has been proposed. These documents disclose a driving method in which the voltage applied to the terminal of the OLED that is not connected to the driving transistor is varied.

In the time ratio gray-scale method, the representation of the gray-scale is implemented by changing the period for which the luminescent elements in one frame are in the complete luminescence state. Accordingly, unlike the area ratio gray-scale method, it is not necessary to provide many sub-pixels for obtaining a greater number of gray-scale levels, and also, the time ratio gray-scale method can be used together with the area ratio gray-scale method. Thus, it is expected that the time ratio gray-scale method will be a promising method for digitally displaying a gray-scale.

However, in the SES (Simultaneous-Erasing-Scan) time ratio gray-scale method, which is reported in "K Inukai, et al., Dig. SID 2000, 924", in addition to the scanning lines, reset lines are required, and thus, the luminescence area is disadvantageously reduced.

EP 1096465A discloses the performing of time division gray-scale display in which the time during which light is emitted by EL elements is arbitrarily set.

EP 1168291A discloses a display device in which fluctuation in luminance of an EL element is controlled and the frequency characteristic of a driver circuit is compensated. The device suppresses a change in the amount of current flowing through the EL element due to a change in the surrounding temperature when the device is in use.

WO 99 42983 discloses another example of electroluminescent display device

Accordingly, a first object of the present invention is to provide a method for implementing the representation of a gray-scale of an electro-optical device without reset lines, and in particular, to provide a method for implementing the representation of the gray-scale of an electro-optical device such as an organic luminescence display device, according to the time ratio gray-scale method. A second object of the present invention is to provide an electro-optical device driven by the above-described driving method.

According to the present invention, there is provided a driving method in accordance with that claimed in claim 1.

Also it is provided an apparatus in accordance with that claimed in claim 9

With this arrangement, since the on-signal is supplied to the switching transistor via the scanning line, and the set signal or the reset signal is supplied via the data line in accordance with the on-signal, the state of the electro-optical element can be selected without a reset line. In this specification, the electro-optical element and the electro-optical device respectively indicate an element and a device in which the luminescence state or the optical characteristic is electrically controlled. Specific examples of the electro-optical device include display devices, such as luminescence display devices, liquid crystal display devices, and electrophoretic display devices.

Throughout the specification, the on-signal indicates a signal for selecting the on-state of the switching transistor. Also, throughout the specification, the "step of supplying a first on-signal to the switching transistor via the scanning line, and of supplying a set signal for selecting a conducting state or a non-conducting state of the driving transistor to the driving transistor via the data line and the switching transistor in accordance with a period for which the first on-signal is supplied" is defined as the "setting step". The "step of supplying a second on-signal to the switching transistor via the scanning line, and of supplying a reset signal for selecting the non-conducting state of the driving transistor to the driving transistor via the data line and the switching transistor in accordance with a period for which the second on-signal is supplied" is defined as the "resetting step". The first on-signal and the second on-signal are not necessarily two consecutive on-signals, and may be discretely set.

A second driving method for an electro-optical device according to the present invention is characterized in that the horizontal scanning period may include a first sub horizontal scanning period for performing the setting step and a second sub horizontal scanning period for performing the resetting step. It is necessary that the first sub horizontal scanning period and the second sub horizontal scanning period be different from each other. Accordingly, the setting step and the resetting step do not overlap with each other. The first sub horizontal scanning period and the second sub horizontal scanning period are not necessarily two consecutive horizontal scanning periods, and may be discretely set. It is not necessary that the first sub horizontal scanning period and the second sub horizontal scanning period be included in the same horizontal scanning period, and may be included in different horizontal scanning periods.

According to a third driving method for an electro-optical device of the present invention, in the above-described driving method for an electro-optical device, the setting step may be performed in a first horizontal scanning period, and the resetting step may be performed in a second horizontal scanning period. It is necessary that the first sub horizontal scanning period and the second sub horizontal scanning period be different from each other. Accordingly, the setting step and the resetting step do not overlap with each other. The setting step and the resetting step do not have to be performed throughout the whole horizontal scanning period, and may be partially performed in the horizontal scanning period. The first sub horizontal scanning period and the second sub horizontal scanning period are not necessarily two consecutive horizontal scanning periods, and may be discretely set.

According to a fourth driving method for an electro-optical device of the present invention, in the above-described driving method for an electro-optical device, a gray-scale may be obtained by performing a plurality of set-reset operations, each set-reset operation including the aforementioned setting step and the resetting step. Accordingly, the state of the electro-optical device is selected in the setting step, and remains the same until the resetting step is performed. Thus, by performing a plurality of set-reset operations, a gray-scale can be obtained. Throughout the specification, the set-reset operation is defined as an operation including the above-described setting step and the resetting step.

According to a fifth driving method for an electro-optical device of the present invention, in the above-described driving method for an electro-optical device, a time interval between the setting step and the resetting step may be different for each of the plurality of set-reset operations.

According to a sixth driving method for an electro-optical device of the present invention, in the above-described driving method for an electro-optical device, the time interval between the setting step and the resetting step for each of the plurality of set-reset operations may be completely different from each other, and the ratio of time intervals for the plurality of set-reset operations may be about 1:2: .. :2ⁿ (n is an integer of one or more). For example, if two set-reset operations with a time interval ratio of 1:2 are performed, four gray-scale levels, i.e., 0, 1, 2, 3, can be displayed. If two set-reset operations with a time interval ratio of 1:1 are performed, three gray-scale levels, i.e., 0, 1, and 2 can be displayed. That is, in this driving method for an electro-optical device, a maximum number of gray-scale levels can be obtained by a minimum number of set-reset operations. The time interval ratio does not have to be precisely 1:2: .. :2ⁿ (n is an integer of one or more), and may be sufficient to such a degree to satisfy a required gray-scale precision.

According to a seventh driving method for an electro-optical device of the present invention, in the above-described driving method for an electro-optical device, the set signal may be a signal for setting the driving transistor to the conducting state rather than the signal for selecting the conducting state or the non-conducting state of the driving transistor. This means that an intermediate conducting state other than the two states, i.e., the conducting state and the non-conducting state, of the driving transistor is selectable. This can be implemented by the set signal provided as a voltage having three or more consecutive or discrete values. This driving method is effective for implementing many gray-scale levels.

According to an eighth driving method for an electro-optical device of the present invention, in the above-described driving method for an electro-optical device, the electro-optical element may be an organic electro-luminescence element. Generally, the power consumption of the organic electro-luminescence element is advantageously low.

An electro-optical device of the present invention is arranged to be driven by the above-described driving method for an electro-optical device.

Embodiments of the present invention will now be described by way of further example only and with reference to the accompanying drawings, in which:-
Fig. 1 illustrates a pixel equivalent circuit of an electro-optical device according to an embodiment of the present invention.
Fig. 2 illustrates a pixel arrangement of an electro-optical device according to an embodiment of the present invention.
Fig. 3 illustrates a driving method for an electro-optical apparatus according to an embodiment of the present invention.
Fig. 4 illustrates a driving method for an electro-optical apparatus according to an embodiment of the present invention.
Fig. 5 illustrates a driving method for an electro-optical apparatus according to an embodiment of the present invention.
Fig. 6 illustrates the current characteristics of a luminescent element according to an embodiment of the present invention.
Fig. 7 illustrates part of a manufacturing process for an electro-optical device according to an embodiment of the present invention.
Fig. 8 illustrates part of a manufacturing process for an electro-optical device according to an embodiment of the present invention.
Fig. 9 illustrates an example of an electro-optical device of an embodiment of the present invention applied to a mobile personal
Fig. 10 illustrates an example of an electro-optical device of an embodiment of the present invention applied to a display unit of a cellular telephone.
Fig. 11 is a perspective view illustrating a digital still camera having a finder to which an electro-optical device of an embodiment of the present invention is applied.

Preferred embodiments of the present invention are described below.

A basic circuit used in an embodiment of the present invention includes a poly-crystal silicon thin-film transistor formed by a low-temperature process at 600°C or lower (low-temperature poly-Si TFT). The low-temperature poly-Si TFT can be formed on a large, inexpensive glass substrate, and can integrate a driving circuit on a panel, and accordingly, it is suitable for manufacturing an electro-optical device. Additionally, the low-temperature poly-Si TFT is small, but has a high current supplying power. Accordingly, it is suitable for use in a high-precision current luminescence display device. The present invention is also applicable to an electro-optical device driven by other types of transistors, such as an amorphous silicon thin-film transistor (a-Si TFT), a silicon-based transistor, and an organic thin-film transistor using an organic semiconductor.

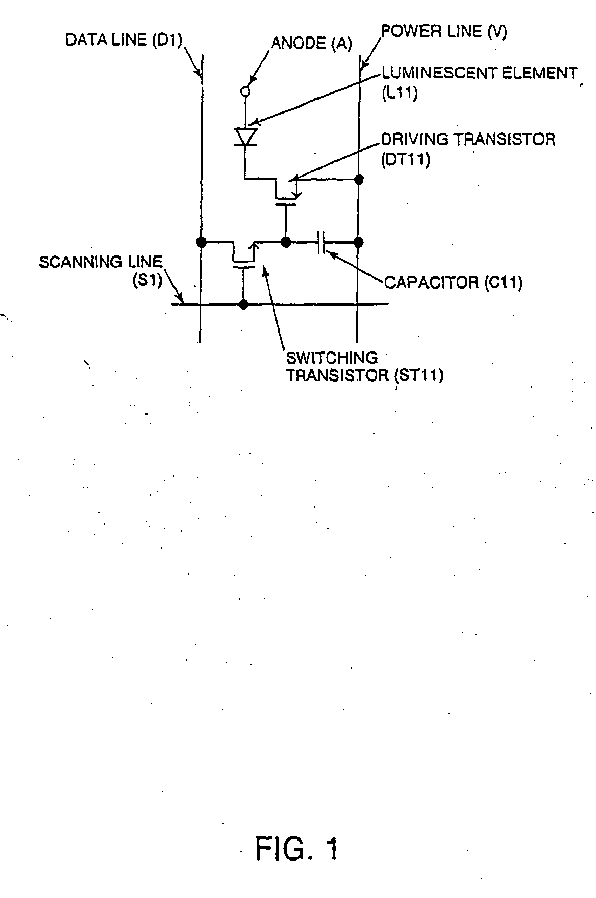

The equivalent circuit of one pixel of an electro-optical device according to an embodiment of the present invention is shown in Fig. 1. In this embodiment, as the electro-optical element, a luminescent element is used. In this electro-optical device, a scanning line (S1), a data line (D1), and a power line (V) are formed, and a luminescent element (L11), a driving transistor (DT11) for driving the luminescent element (L11), a switching transistor (ST11) for controlling this driving transistor (DT11), and a capacitor (C11) are provided at the intersection of the scanning line (S1) and the data line (D1). One end of the luminescent element (L11) is connected to an anode (A). The driving transistor (DT11) is p-type. Accordingly, the driving transistor (DT11) enters a conducting state selected by a low-potential data signal to cause the luminescent element (L11) to be in the luminescence state. In contrast, the driving transistor (DT11) enters a non-conducting state selected by a high-potential data signal to cause the luminescent element (L11) to be in the non-luminescence state. In the pixel equivalent circuit shown in Fig. 1, the switching transistor (ST11) is n-type, and the driving transistor (DT11) is p-type. However, this is not a limitation to implement the present invention.

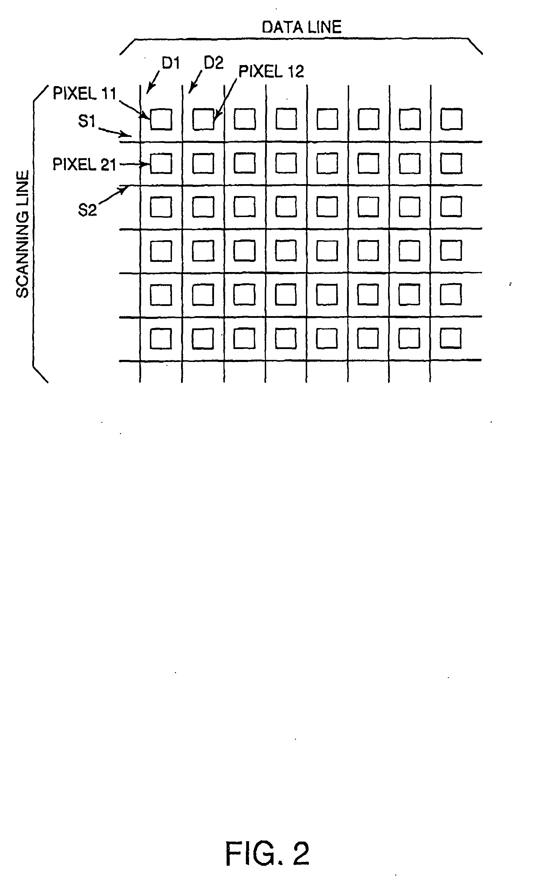

Fig. 2 illustrates wiring and a pixel arrangement of an electro-optical device according to an embodiment of the present invention. Pixels are arranged in a matrix by a plurality of scanning lines (S1, S2, ....) and a plurality of data lines (D1, D2, ....), and a plurality of pixels are formed at corresponding intersections of the scanning lines and the data lines. For example, a pixel 11 is provided at the intersection of S1 and D1. Basically, the pixel includes a switching transistor (ST11), a capacitor (C11), a driving transistor (DT11), and a luminescent element (L11), such as those shown in Fig. 1. However, the pixel may include a plurality of sub-pixels. A power line is not shown in Fig. 2.

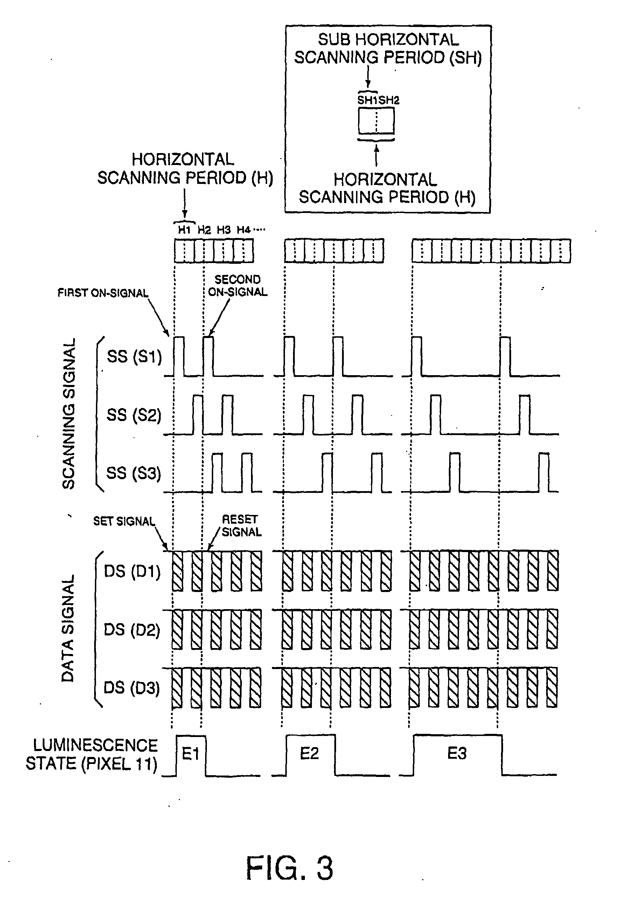

Fig. 3 illustrates a driving method for an electro-optical device according to an embodiment of the present invention. In this driving method, a horizontal scanning period (H) comprises two sub horizontal scanning periods (SH1 and SH2). The scanning signal and the data signal are either a high-potential signal or a low-potential signal. A first scanning signal SS(S1) is supplied to the first scanning line (S1). A second scanning signal SS(S2) is supplied to the second scanning line (S2). A third scanning signal SS(S3) is supplied to the third scanning line (S3). A first data signal DS(D1) is supplied to the first data line (D1). A second data signal DS(D2) is supplied to the second data line (D2). A third data signal DS(D3) is supplied to the third data line (D3). In DS(D1), DS(D2), and DS(D3), the hatched portions indicate a set signal, while the other portions indicate a reset signal. A low-potential data signal, which causes the luminescent element to be in the luminescence state, is supplied as the set signal. For causing the luminescent element to be in the non-luminescence state, a high-potential set signal is supplied.

In the sub horizontal scanning period SH1 of the horizontal scanning period H1, the luminescent element is set to be in the luminescence state or the non-luminescence state by a setting step of "supplying a first on-signal to the switching transistor (ST11) via the scanning line (S1), and of supplying the set signal for selecting the conducting state or the non-conducting state of the driving transistor (DT11) to the driving transistor (DT11) via the data line D1 and the switching transistor (ST11) in accordance with the period for which the first on-signal is supplied". In the sub horizontal scanning period SH2 of the horizontal scanning period H2, the luminescent element is set to be in the non-luminescence state by a resetting step of "supplying a second on-signal to the switching transistor (ST11) via the scanning line (51), and of supplying the reset signal for selecting the non-conducting state of the driving transistor (DT11) to the driving transistor (DT11) via the data line D1 and the switching transistor (ST11) in accordance with the period for which the second on-signal is supplied". According to the above-described setting step and resetting step, the luminescence period (E1) of the first-row and first-column pixel 11 is set. It may take some time for the transistor or the luminescent element to respond to the corresponding signal. Accordingly, as shown in Fig. 3, the start time and the end time of the luminescence period may be displaced from the start of the setting step and the start of the resetting step, respectively. In Fig. 3, the period for which the first on-signal is supplied coincides with the period for which the set signal is supplied, and the period for which the second on-signal is supplied coincides with the period for which the reset signal is supplied. However, depending on the circumstances of the use or the specifications, the on-signal does not always have to coincide with the set signal or the reset signal.

The setting step and the resetting step for the subsequent scanning line (S2) are performed such that they are displaced from those for the scanning line (S1). As shown in Fig. 3, they are preferably performed at times closest to those for the scanning line (S1). Thereafter, similarly, the setting step and the resetting step are performed for the third scanning line (S3) and the subsequent scanning lines. Then, one vertical scanning period is finished. For the subsequent vertical scanning period, the setting step and the resetting step are similarly performed for each scanning line. The ratio of the luminescence periods E1, E2, and E3 is about 1:2:4. As a result, eight gray-scale levels, such as 0, 1, 2, 3, 4, 5, 6, and 7, are obtained.

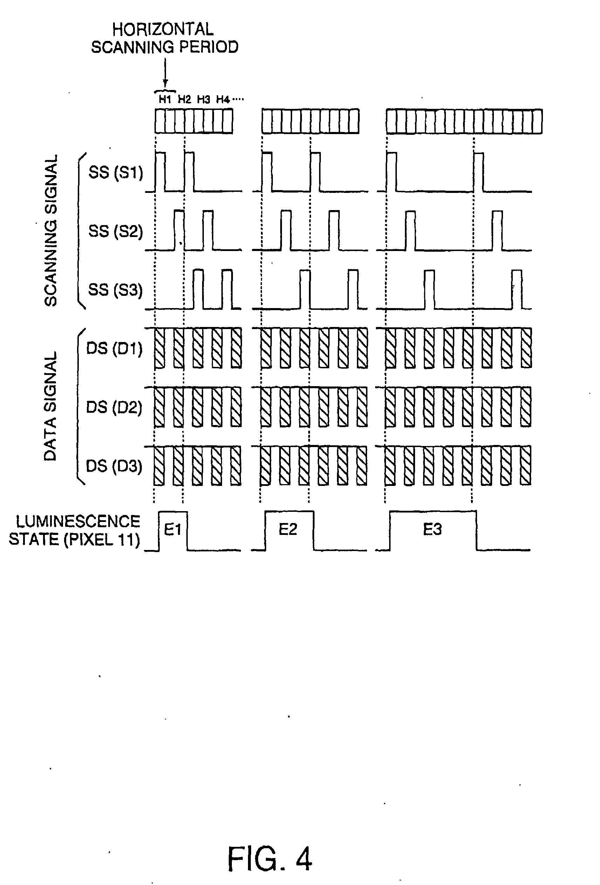

In the embodiment shown in Fig. 3, one horizontal scanning period is divided into two sub horizontal scanning periods. However, as shown in Fig. 4, the setting step and the resetting step may be set in units of horizontal scanning periods. In Fig. 4, the period of the setting step and the period of the resetting step respectively coincide with the horizontal scanning period. However, neither the setting step nor the resetting step has to be performed throughout the whole horizontal scanning period.

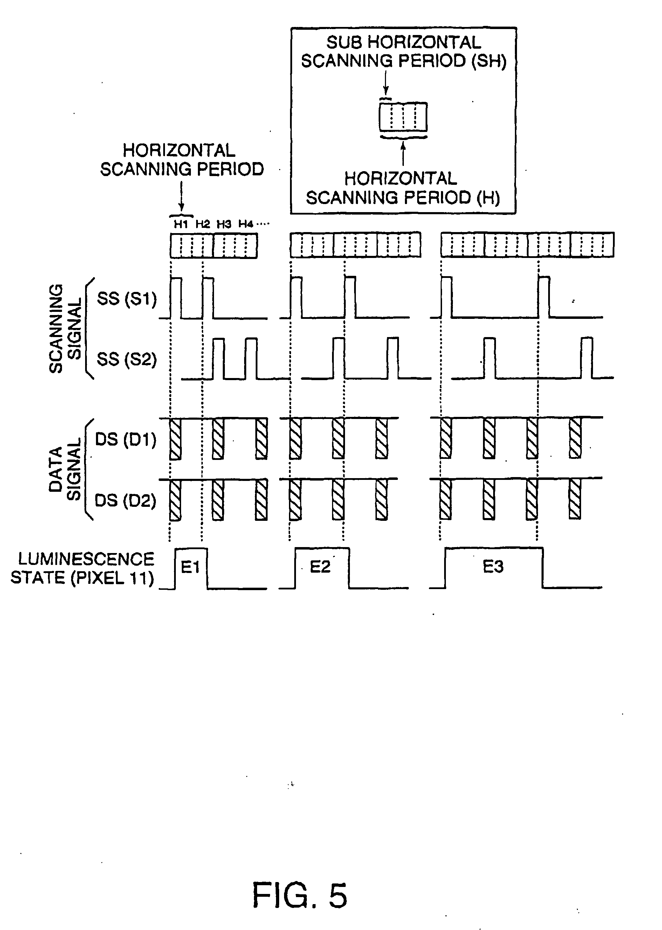

Among a plurality of set-reset operations, a set-reset operation may be partially or wholly performed during the same horizontal scanning period. Such an embodiment is shown in Fig. 5. In this embodiment, the setting step and the resetting step are performed in units of sub horizontal scanning periods (SH) which are obtained by dividing the horizontal scanning period (H) into four. The first set-reset operation is performed in the same horizontal scanning period. In the second and the subsequent set-reset operations, the horizontal scanning period of the sub horizontal scanning period for which the setting step is performed is different from that of the sub horizontal scanning period for which the resetting step is performed. In each vertical scanning period, upon completion of the horizontal scanning period for the first scanning line (S1), the set-reset operation is started for the second scanning line (S2). Thereafter, the set-reset operation is similarly formed for the third scanning line (S3) and the subsequent scanning lines.

In any of the driving methods for the electro-optical devices shown in Figs. 3 through 5, the set-reset operations are sequentially performed such that the time interval between the setting step and the resetting step is increased. However, the set-reset operations do not have to be performed in this order, and it can be performed according to the circumstances of the use or the specifications. As in the driving methods for the electro-optical devices shown in Figs. 3 through 5, for simplicity of a peripheral circuit system, such as a data line driver, the reset signal is preferably supplied at regular intervals. However, it is not essential that the reset signal be supplied at regular intervals, and the timing for supplying the on-signal and the reset signal to the switching transistor can suitably be set according to the desired luminescence period.

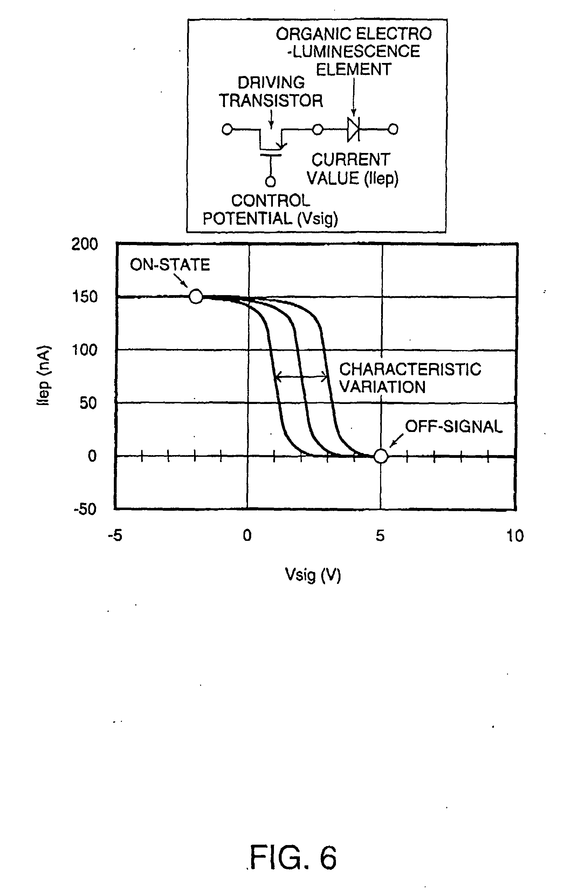

Fig. 6 illustrates current characteristics of the luminescent element according to an embodiment of the present invention. The horizontal axis represents control potential (Vsig) supplied to the gate electrode of the driving transistor, and the vertical axis designates current value (IIep) of the organic electro-luminescence device. The current value and the luminance of the organic electro-luminescence device are substantially proportional to each other. Thus, it can be considered that the vertical axis also indicates the luminance. In this embodiment, it is preferable that the organic electro-luminescence device is unambiguously controlled to be either in the on state or the off state. When the electro-luminescence device is unambiguously in the on state or in the off state, the current value (IIep) is substantially constant. Thus, a variation in the transistor characteristics does not change the current value of the luminescent element, and accordingly, the luminance substantially becomes uniform. Therefore, the image quality can be uniform.

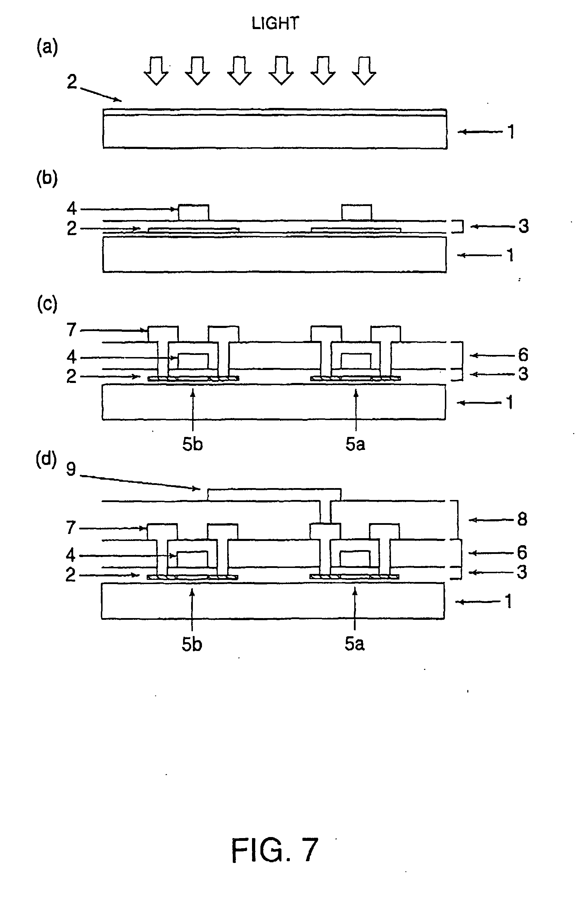

Fig. 7 illustrates a manufacturing process for a thin-film transistor for use in the electro-optical device according to an embodiment of the present invention. Amorphous silicon is first formed on a glass substrate 1 by PECVD using SiH₄ or by LPCVD using Si₂H₆. The amorphous silicon is poly-crystallized by a laser, such as an excimer laser, or by solid-phase growth, thereby forming a poly-crystalline silicon layer 2 (Fig. 7(a)). After the poly-crystalline silicon layer 2 is patterned, a gate insulating film 3 is formed, and gate electrodes 4 are further formed (Fig. 7(b)). An impurity, such as phosphorus or boron, is implanted into the poly-crystalline silicon layer 2 by the gate electrodes 4 according to a self-alignment process so as to form MOS transistors 5a and 5b. The MOS transistors 5a and 5b are a p-type transistor and an n-type transistor, respectively. After a first interlayer insulating film 6 is formed, contact holes are formed, and a source electrode and a drain electrode 7 are formed (Fig. 7(c)). Then, after a second interlayer insulating film 8 is formed, contact holes are formed, and a pixel electrode 9 comprising ITO is formed (Fig. 7(d)).

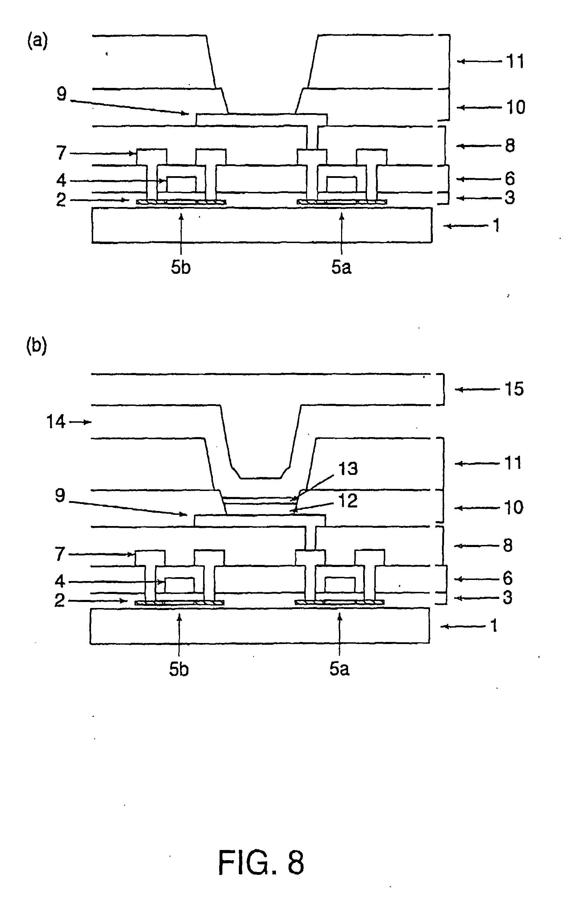

Fig. 8 illustrates a manufacturing process for pixels used in the electro-optical device according to an embodiment of the present invention. First, an adhesion layer 10 is formed, and an opening corresponding to a luminescent region is formed. An interlayer 11 is then formed, and an opening is formed (Fig. 8(a)). Then, the wettability of the substrate surface is controlled by performing plasma processing using, for example, oxygen plasma or CF₄ plasma. Subsequently, an electron-hole implantation layer 12 and a luminescent layer 13 are formed according to a liquid-phase process, such as a spin coating, squeegee, or ink-jet process, or a vacuum process, such as sputtering or deposition. An anode 14 containing metal, such as aluminum, is then formed. Finally, a sealing layer 15 is formed. Thus, an organic electro-luminescence device is manufactured (Fig. 8(b)). The roles of the adhesion layer 10 are to improve the adhesion between the substrate and the interlayer 11 and also to obtain an accurate luminescence area. The roles of the interlayer 11 are to reduce the parasitic capacitance by separating the gate electrodes 4, the source electrodes, and the drain electrodes 7 from the anode 14, and also to perform precise patterning by controlling the surface wettability when forming the electron-hole implantation layer 12 and the luminescent layer 13 by a liquid-phase process.

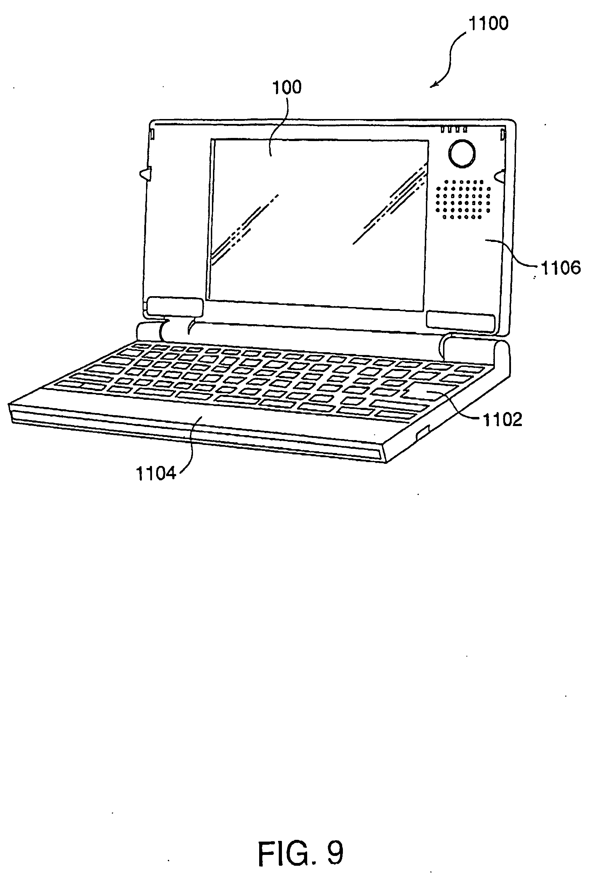

Some examples of electronic apparatuses using the above-described electro-optical device are described below. Fig. 9 is a perspective view illustrating the configuration of a mobile personal computer to which the above-described electro-optical device is applied. In Fig. 9, a personal computer 1100 includes a main unit 1104 provided with a keyboard 1102, and a display unit 1106. The display unit 1106 is provided with the above-described electro-optical device 100.

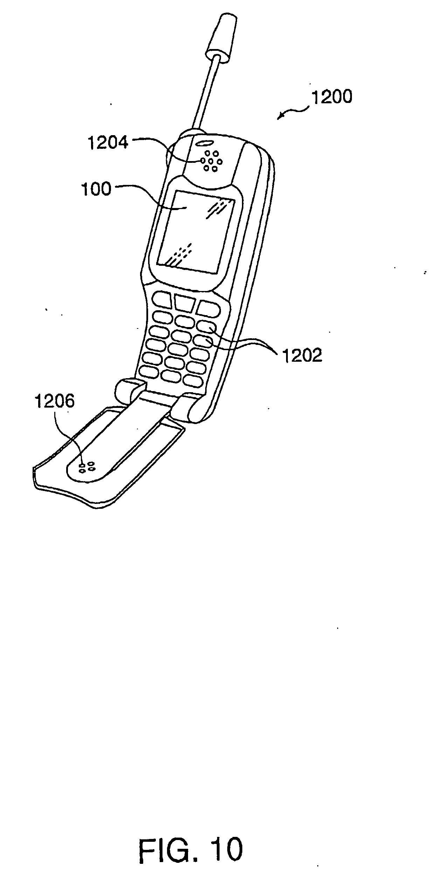

Fig. 10 is a perspective view illustrating the configuration of a cellular telephone having a display unit to which the aforementioned electro-optical device 100 is applied. In Fig. 10, a cellular telephone 1200 includes, not only a plurality of operation buttons 1202, but also the above-described electro-optical device 100 together with an earpiece 1204 and a mouthpiece 1206.

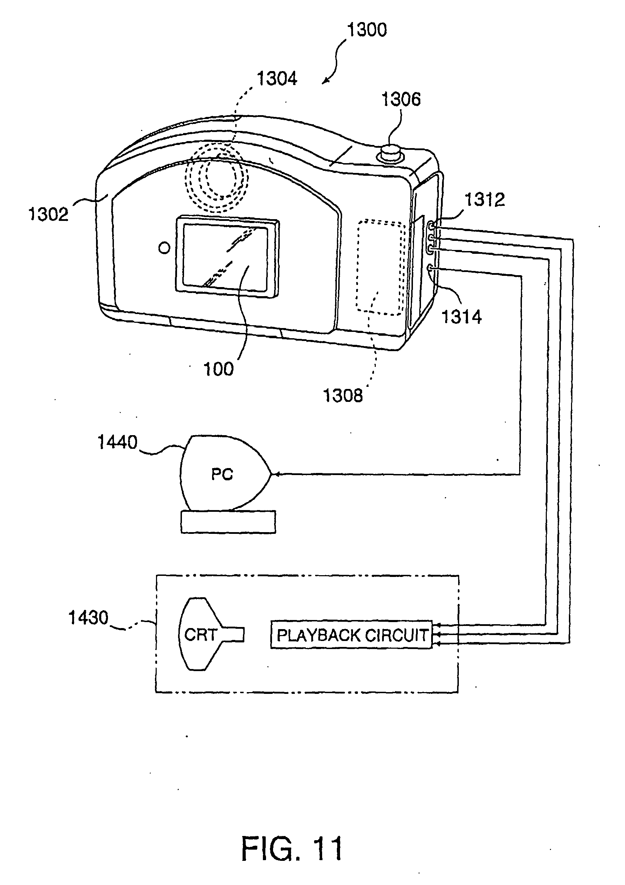

Fig. 11 is a perspective view illustrating the configuration of a digital still camera having a finder to which the above-described electro-optical device 100 is applied. Fig. 11 also schematically illustrates the connection of the digital still camera with external devices. In a regular camera, a film is exposed to light by an optical image of a subject. In a digital still camera 1300, however, an optical image of a subject is photoelectrically converted by an image pickup device, such as a CCD (Charge Coupled Device) so as to generate an imaging signal. On the rear surface of a casing 1302 of the digital still camera 1300, the aforementioned electro-optical device 100 is provided to display the subject based on the imaging signal obtained by the CCD. That is, the electro-optical device 100 serves as a finder for displaying the subject. On the observation side (on the reverse surface in Fig. 11) of the casing 1302, a photodetector unit 1304 including an optical lens and a CCD is disposed.

A photographer checks the subject displayed on the electro-optical device 100 and presses a shutter button 1306. Then, an imaging signal obtained by the CCD is transferred to and stored in a memory of a circuit board 1308. In this digital still camera 1300, a video signal output terminal 1312 and a data communication input/output terminal 1314 are provided on the side surface of the casing 1302. Then, as shown in Fig. 11, a television monitor 1430 and a personal computer 1440 are connected to the video signal output terminal 1312 and the data communication input/output terminal 1314, respectively, as required. The imaging signal stored in the memory of the circuit board 1308 is output to the television monitor 1430 or the personal computer 1440 by a predetermined operation.

Electronic apparatuses to which the electro-optical device 100 of the present invention is applicable include, not only the personal computer shown in Fig. 9, the cellular telephone shown in Fig. 10, and the digital still camera shown in Fig. 11, but also a liquid crystal television, a view-finder-type or direct-view-type video cassette recorder, a car navigation system, a pager, an electronic diary, a calculator, a word processor, a workstation, a videophone, a POS terminal, a device provided with a touch panel, for example. It is needless to say that the above-described electro-optical device 100 is applicable to the display units of these electronic apparatuses.

## Claims

1. A driving method for an electro-optical gray-scale matrix display device which comprises, at an intersection of a scanning line (S1) and a data line (D1), an electro-optical element (L11), a driving transistor (DT11) for driving the electro-optical element by controlling the supply of power between a power line and the electro-optical element, and a switching transistor (ST11) for controlling the driving transistor, the driving method comprising:
a setting step of supplying a first on-signal to the switching transistor via the scanning line, and of supplying a set signal for selecting a conducting state or a non-conducting state of the driving transistor to the driving transistor via the data line and the switching transistor in accordance with a first period for which the first on-signal is supplied;
**characterised in that** the method further comprises :
a resetting step of supplying a second on-signal to the switching transistor via the scanning line, and of supplying a reset signal for selecting the non-conducting state of the driving transistor to the driving transistor via the data line and the switching transistor in accordance with a second period for which the second on-signal is supplied,
wherein
the reset signal is outputted to the data line at a constant frequency.

2. A driving method for an electro-optical device according to claim 1, wherein a horizontal scanning period (H) comprises a first sub horizontal scanning period (SH1) for performing the setting step and a second sub horizontal scanning period (SH2) for performing the resetting step.

3. A driving method for an electro-optical device according to claim 1, wherein the setting step is performed in a first horizontal scanning period, and the resetting step is performed in a second horizontal scanning period.

4. A driving method for an electro-optical device according to any one of claims 1 to 3, wherein a gray-scale is obtained by performing a plurality of set-reset operations, each set-reset operation comprising the setting step and the resetting step.

5. A driving method for an electro-optical device according to claim 4, wherein a time interval between the setting step and the resetting step is different for each of the plurality of set-reset operations.

6. A driving method for an electro-optical device according to claim 5, wherein the ratio of time intervals for the plurality of set-reset operations is set to be about 1:2: .. :2ⁿ (n is an integer of one or more) based on the minimum time interval.

7. A driving method for an electro-optical device according to any one of claims 1 to 6, wherein the set signal is a signal for setting the amount of conductance of the conducting state for the driving transistor.

8. A driving method for an electro-optical device according to any one of claims 1 to 7, wherein the electro-optical element comprises an organic electro-luminescence element.

9. An electro-optical device arranged to be driven by a driving method as set forth in any one of claims 1 to 8.

## Patentansprüche

1. Ansteuerverfahren für eine elektrooptische Grauskalenmatrix-Anzeigevorrichtung, die, an einem Schnittpunkt einer Abtastleitung (S1) und einer Datenleitung (D1), ein elektrooptisches Element (L11), einen Treibertransistor (DT11) zum Ansteuern des elektrooptischen Elements durch Steuern der Stromzufuhr zwischen einer Stromleitung und dem elektrooptischen Element, und einen Schalttransistor (ST11) zum Steuern des Treibertransistors umfasst, wobei das Ansteuerverfahren umfasst:
einen Einstellschritt zum Zuleiten eines ersten Ein-Signals zu dem Treibertransistor über die Abtastleitung, und zum Zuleiten eines Einstellsignals zum Auswählen eines leitenden Zustands und eines nicht leitenden Zustands des Treibertransistors zu dem Treibertransistor über die Datenleitung und den Schalttransistor in Übereinstimmung mit einer ersten Periode, in der das erste Einstellsignal zugeleitet wird;
**dadurch gekennzeichnet, dass** das Verfahren des Weiteren umfasst:
einen Rückstellschritt zum Zuleiten eines zweiten Ein-Signals zu dem Treibertransistor über die Abtastleitung, und zum Zuleiten eines Rückstellsignals zum Auswählen des nicht leitenden Zustands des Treibertransistors zu dem Treibertransistor über die Datenleitung und den Schalttransistor in Übereinstimmung mit einer zweiten Periode, in der das zweite Einstellsignal zugeleitet wird; wobei
das Rückstellsignal bei einer konstanten Frequenz an die Datenleitung ausgegeben wird.

2. Ansteuerverfahren für eine elektrooptische Vorrichtung nach Anspruch 1, wobei eine horizontale Abtastperiode (H) eine erste subhorizontale Abtastperiode (SH1) zur Durchführung des Einstellschrittes und eine zweite subhorizontale Abtastperiode (SH2) zur Durchführung des Rückstellschrittes umfasst.

3. Ansteuerverfahren für eine elektrooptische Vorrichtung nach Anspruch 1, wobei der Einstellschritt in einer ersten horizontalen Abtastperiode durchgeführt wird und der Rückstellschritt in einer zweiten horizontalen Abtastperiode durchgeführt wird.

4. Ansteuerverfahren für eine elektrooptische Vorrichtung nach einem der Ansprüche 1 bis 3, wobei eine Grauskala durch Ausführen mehrerer Einstell-Rückstelloperationen erhalten wird, wobei jede Einstell-Rückstelloperation den Einstellschritt und den Rückstellschritt umfasst.

5. Ansteuerverfahren für eine elektrooptische Vorrichtung nach Anspruch 4, wobei ein Zeitintervall zwischen dem Einstellschritt und dem Rückstellschritt für jede der mehreren Einstell-Rückstelloperationen unterschiedlich ist.

6. Ansteuerverfahren für eine elektrooptische Vorrichtung nach Anspruch 5, wobei das Verhältnis der Zeitintervalle für die mehreren Einstell-Rückstelloperationen auf etwa 1:2:...:2ⁿ (n ist eine ganze Zahl von Eins oder mehr) eingestellt ist, basierend auf dem minimalen Zeitintervall.

7. Ansteuerverfahren für eine elektrooptische Vorrichtung nach einem der Ansprüche 1 bis 6, wobei das Einstellsignal ein Signal zum Einstellen des Ausmaßes der Leitfähigkeit des leitenden Zustands für den Treibertransistor ist.

8. Ansteuerverfahren für eine elektrooptische Vorrichtung nach einem der Ansprüche 1 bis 7, wobei das elektrooptische Element ein organisches Elektrolumineszenzelement umfasst.

9. Elektrooptische Vorrichtung, die dazu angeordnet ist, durch ein Ansteuerverfahren nach einem der Ansprüche 1 bis 8 angesteuert zu werden.

## Revendications

1. Méthode de commande pour un dispositif d'affichage à matrice à niveaux de gris électro-optique lequel comprend, à une intersection entre une ligne de balayage (S1) et une ligne de données (D1), un élément électro-optique (L11), un transistor d'attaque (DT11) pour commander l'élément électro-optique en contrôlant l'alimentation en énergie entre une ligne de force et l'élément électro-optique, et un transistor de commutation (ST11) pour contrôler le transistor d'attaque, la méthode de commande comprenant :
une étape de réglage consistant à fournir un premier signal allumé au transistor de commutation via la ligne de balayage, et à fournir un signal de réglage pour sélectionner un état passant ou un état de non passant du transistor d'attaque au transistor d'attaque via la ligne de données et le transistor de commutation en fonction d'une première période pendant laquelle le premier signal allumé est fournit ;
**caractérisée en ce que** la méthode comprenne par ailleurs :
une étape de remise à zéro consistant à fournir un deuxième signal allumé au transistor de commutation via la ligne de balayage, et à fournir un signal de remise à zéro pour sélectionner l'état non passant du transistor d'attaque au transistor d'attaque via la ligne de données et le transistor de commutation en fonction d'une deuxième période pendant laquelle le deuxième signal allumé est fournit ;
le signal de remise à zéro étant émis à l'attention de la ligne de données à une fréquence constante.

2. Méthode de commande pour un dispositif électro-optique selon la revendication 1, une période de balayage horizontal (H) comprenant une première période de sous-balayage horizontal (SH1) pour réaliser l'étape de réglage et une deuxième période de sous-balayage horizontal (SH2) pour réaliser l'étape de remise à zéro.

3. Méthode de commande pour un dispositif électro-optique selon la revendication 1, l'étape de réglage étant réalisée lors d'une première période de balayage horizontal, et l'étape de remise à zéro étant réalisée lors d'une deuxième période de balayage horizontal.

4. Méthode de commande pour un dispositif électro-optique selon l'une quelconque des revendications 1 à 3, des niveaux de gris étant obtenus en réalisant une pluralité d'opérations de réglage-remise à zéro, chaque opération de réglage-remise à zéro comprenant l'étape de réglage et l'étape de remise à zéro.

5. Méthode de commande pour un dispositif électro-optique selon la revendication 4, un intervalle de temps entre l'étape de réglage et l'étape de remise à zéro étant différent pour chacune parmi la pluralité des opérations de réglage-remise à zéro.

6. Méthode de commande pour un dispositif électro-optique selon la revendication 5, le rapport des intervalles de temps pour la pluralité des opérations de réglage-remise à zéro étant environ de 1:2:.. :2ⁿ(n étant un entier de un ou plus) sur la base de l'intervalle de temps minimal.

7. Méthode de commande pour un dispositif électro-optique selon l'une quelconque des revendications 1 à 6, le signal de réglage étant un signal pour régler la quantité de conductance de l'état de conduction du transistor d'attaque.

8. Méthode de commande pour un dispositif électro-optique selon l'une quelconque des revendications 1 à 7, l'élément électro-optique comprenant un élément électroluminescent organique.

9. Dispositif électro-optique étudié pour être commandé grâce à une méthode de commande telle qu'exposée dans l'une quelconque des revendications 1 à 8.
